# EUROPEAN PATENT SPECIFICATION

(11) **EP 1 875 139 B1**
(45) Date of publication and mention of the grant of the patent: **16.12.2009**
(21) Application number: 05718525.8
(22) Date of filing: 22.04.2005
(51) Int. Cl.: F24F 11/00

(54) **INTELLIGENT FAN ASSISTED TILES FOR ADAPTIVE ENVIRONMENTAL MANAGEMENT**
INTELLIGENTE GEBLÄSEPLATTEN ZUR ADAPTIVEN UMGEBUNGSVERWALTUNG
PAVES INTELLIGENTS ASSISTES PAR VENTILATEUR SERVANT A EFFECTUER UNE GESTION ADAPTATIVE DE L'ENVIRONNEMENT

(43) Date of publication of application: 09.01.2008
(73) Proprietor: Degree Controls, Inc., Milford, NH 03055-4612 (US)
(72) Inventor: NAIR, Rajesh M., Nashua, NH 03063 (US)
(74) Representative: Green, Mark Charles
(86) International application number: PCT/IB2005/001130
(87) International publication number: WO 2006/111789

(56) References cited:
- US-A- 5 910 045
- US-A1- 2004 074 249
- US-A1- 2005 075 065
- US-B1- 6 557 624
- PATENT ABSTRACTS OF JAPAN vol. 016, no. 195 (M-1246), 12 May 1992 (1992-05-12) & JP 04 028934 A (MATSUSHITA SEIKO CO LTD), 31 January 1992 (1992-01-31)
- PATENT ABSTRACTS OF JAPAN vol. 017, no. 574 (M-1498), 19 October 1993 (1993-10-19) & JP 05 164394 A (TAKENAKA KOMUTEN CO LTD), 29 June 1993 (1993-06-29)

## Description

### Technical Field of the Invention

The present invention relates generally to environmental management of rooms, and more particularly to thermal and/or airflow management of a computer data center.

### Background of the Invention

The computer data centers typically, consist thousands of racks each with multiple computing units. The computing units can include multiple microprocessors, each dissipating approximately 250 W of power. The heat dissipation from a rack containing such computing units can exceed 10 KW. Today's computer data center, with about 1000 racks and occupying over 30,000 square feet can require about 10 MW of power for the computing infrastructure. A 100,000 square foot computer data center of tomorrow can require 50 MW of power for the computing infrastructure. Energy required to dissipate this heat can be an additional 20 MW. A hundred thousand square foot planetary scale computer data center, with five thousand 10 KW racks, can cost about 44 million dollars per year (at $100/MWh) just to power the servers and about 18 million dollars per year to power the cooling infrastructure for the computer data center.

Cooling design consideration by virtue of proper layout of racks and fans can yield substantial savings in energy. Generally, cooling design in a high power density computer data center is quite complex. Today's intuitive distribution of air does not suffice in providing a well-balanced airflow in a computer data center such that every location in the computer data center receives a uniform airflow to improve operating efficiency and cooling performance.

In addition, many of the computer data centers are hastily planned and implemented as the needed equipment must be quickly installed on a rush schedule. The typical result is a somewhat haphazard layout on the raised floor

That can have disastrous consequences due to environmental temperature disparities. Unfortunately, the dangers of this lack of planning are, is not apparent until after serious reliability problems have already occurred. Further, any changes in a computer data center due to traffic patterns, equipment changes and additions, blocked filters, failed fans, and so on can affect thermal load distribution, which in turn can affect the well-balanced airflow in a computer data center.

In US 2005/0075065 (Nair), there is described a thermal management system for a room having heat generating components, the system comprising an array of fan assisted tiles, a fan controller coupled to each fan assisted tile, and a thermal server coupled to each fan controller through a data network to receive sensed data based on environmental characteristics in the room and to output a control signal to each fan controller so that the fans of each fan assisted tile can be controlled to provide an adaptive airflow balancing in the room.

However, there is a need for a system which can more accurately monitor the room environment.

### Summary of the Invention

The present invention provides a technique for providing a well-balanced airflow in a room having many heat generating elements, such as a computer data center. In one example embodiment, the technique provides dynamic airflow balancing and thermal management for the computer data center. This is accomplished by disposing multiple fan tiles at various locations in a raised floor and ceiling of a computer data center that are connected to a host computer through a data network. Each of the disposed networked fan tiles in the raised floor and the ceiling is controlled by the host computer based on sensing incoming airflow and outgoing air temperature, respectively, to achieve well-balanced airflow in the computer data center. The invention is as defined in claims 1 and 6 attached hereto.

### Brief Description of the Drawings

FIG. 1 is a schematic diagram of a side elevational view of one example embodiment of a computer data center including multiple fan assisted tiles according to the present subject matter.
FIG. 2 is a block diagram of a fan assisted tile shown in FIG. 1 according to the present subject matter.
FIG. 3 is a flowchart illustrating a method of providing adaptive airflow balancing in a room, in accordance with one embodiment of the present subject matter.

### Detailed Description of the Invention

The present subject matter provides a technique for providing environmental control of a room, such as a well-balanced airflow or thermal/temperature control in the room. Such environmental control may be critical to proper operation of equipment in the room. Rooms, such as semiconductor and pharmaceutical clean rooms may not be thermally sensitive, but may have airflow requirements that are critical for containment or particle control. Heat generating equipment, such as computer components may need to be cooled to properly operate. The technique further provides a dynamic airflow balancing and thermal management for a computer data center.

In the following detailed description of the embodiments of the invention, reference is made to the accompanying drawings that form a part hereof, and in which are shown by way of illustration specific embodiments in which the invention may be practiced. These embodiments are described in sufficient detail to enable those skilled in the art to practice the invention, and it is to be understood that other embodiments may be utilized and that changes may be made without departing from the scope of the present invention as defined by the appended claims. The following detailed description is, therefore, not to be taken in a limiting sense, and the scope of the present invention is defined only by the appended claims. The terms "thermal server", "host computer", "remote server", and "remote computer" are used interchangeably throughout the document. In addition, the terms "power controller" and "micro-controller" are also used interchangeably throughout the document and refer to a means used to vary the speed of the one or more fans in the fan tile assembly.

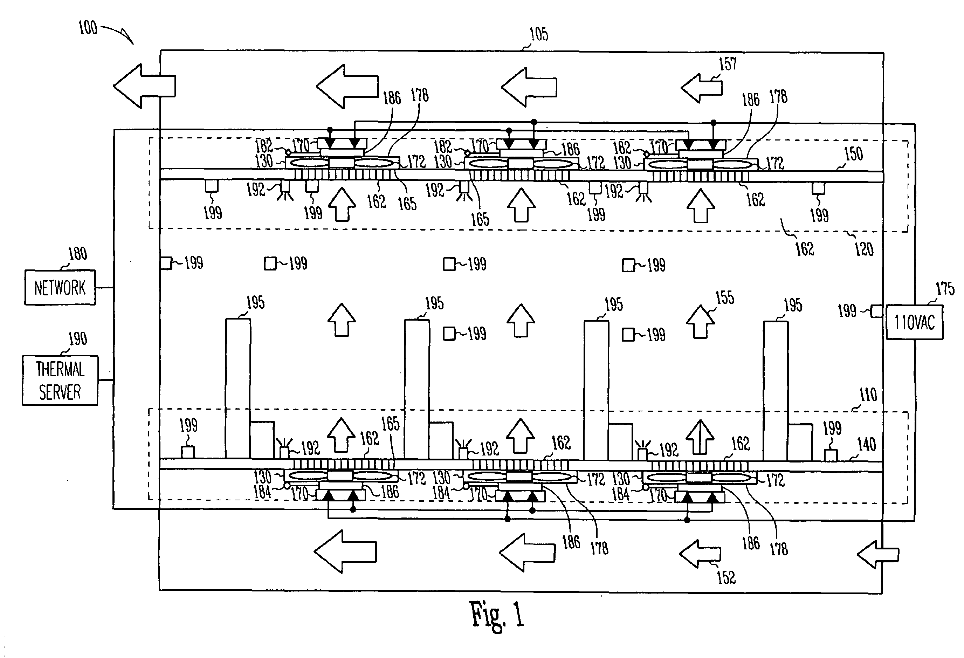

Referring now to FIG. 1, there is illustrated an example embodiment of a thermal management system 100 according to the present subject matter. The thermal management system 100 includes a first array 110 of fan assisted tiles 130, disposed in the raised floor 140 of a room 105, and a second array 120 of fan assisted tiles 130, disposed in the ceiling 150 of the room 105. The room 105 can be a computer data center including heat generating components 195.

As shown in FIG. 1, each fan assisted tile 130 includes a plurality of passageways 162 for the air to enter and exhaust from the room 105. Further as shown in FIG. 1, each fan assisted tile 130 can be attached to a fan tile 135 that is adaptable to be disposed on the ceiling 150 and/or the raised floor 140 of the room 105. In some embodiments, the fan tile 135 is made of sheet metal tile. In these embodiments, the sheet metal tile has a front side 165 and a back side 178. One or more fans 172 are attached to the back side 178 of the sheet metal tile. The front side 165 of the sheet metal tile is adapted to be disposed on the raised floor 140 and/or ceiling 150 in the room 105.

Also shown in FIG.1, the thermal management system 100 includes a power source 175, a data network 180, and a remote thermal server 190. The thermal server 190 can be a host computer, a remote server, a remote computer, a remote server, a processor, and other such processors that can facilitate in the thermal management of the room 105. The thermal server 190 can be a remote program capable of communicating over a data network 180. As shown in FIG. 1, each of the fan assisted tiles 130 includes the one or more fans 172, a power controller 186, and an interface 170. In the example embodiment shown in FIG. 1, each of the power controllers 186 is connected to the power source 175 through the interface 170. In addition, as shown in FIG. 1, each of the fan assisted tiles 130 is connected to the thermal server 190 through the interface 170 and via the data network 180. The interface 170 can be a network interface, such as a serial communication interface.

The network may also be a wireless network, with each device in the network having an interface 170 with a transceiver for implementing one of many wireless protocols. In some embodiments, sensors may have transceivers, or may have only transmitters, and transmit information representative of sensed parameters, such as temperature, airflow, etc.

In these embodiments, the first array 110 of fan assisted tiles 130 is disposed on the raised floor 140 such that the air is directed into the room 105 as indicated by directional arrows 152. The second array 120 of fan assisted tiles 130 is disposed in the ceiling 150 such that the air is directed out of the room 105 as indicated by directional arrows 157. In operation, the thermal management system 100 moves the air in the room 105 through the passageways 162 as indicated by directional arrows 152, 155, and 157 to provide adaptive airflow balancing in the room 105.

Also shown in FIG. 1, an airflow sensor 184 is coupled to each of the power controllers 186 in the first array 110 of fan assisted tiles 130. Further, FIG.1 shows a temperature sensor 182 coupled to each of the power controllers 186 in the second array 120 of fan assisted tiles 130.

FIG. 1 illustrates an example centralized control system for the adaptive control of the environment, such as the room 105. The centralized control in this example embodiment is achieved through the thermal server 190, which communicates with the fan assisted tiles 130 via the network 180. In this example embodiment, the thermal server 190 receives the sensor information, such as airflow and temperature and computes necessary operating parameters, such as fan speed and other commands necessary to operate the fan assisted tiles 130. The computed operating parameters are then sent over the network 180 to each of the fan assisted tiles 130 to provide an adaptive control in the room 105.

In a further embodiment, a network of temperature sensors 199 are dispersed throughout the room, and provide temperature information to the thermal server 190. In one embodiment, the temperatures sensors provide a temperature map of the room. The detail or granularity of the map is dependent on the number, density and placement of the temperature sensors. Such sensors may be placed anywhere in the room, such as near sensitive equipment that may have special thermal needs, or uniformly on the ceiling of the room, or anywhere else desired. The thermal server in one embodiment, monitors the temperature information and provides trend monitoring. Trend monitoring may be used to identify trends in temperature which are known to be indicative of undesired heat buildup or possibly a cooling failure. Such trends, or patterns in the data may be learned, or pre-programmed in by operators based on historical analysis of the data and identification of patterns associated with undesired events.

In one embodiment, the cooling tiles contain controllable inlet and outlet vents. The vents may be part of the cooling tile passageways 162 and controlled by the thermal server 190 through the tiles to provide better control of airflow, or may be a separate networked device, receiving commands and optionally providing data directly to the thermal server. In such instances, the vents may be anywhere in the room, even separate from the tiles. The thermal server may monitor temperatures from the network of temperature sensors, and control the vents to manage the temperatures in the room.

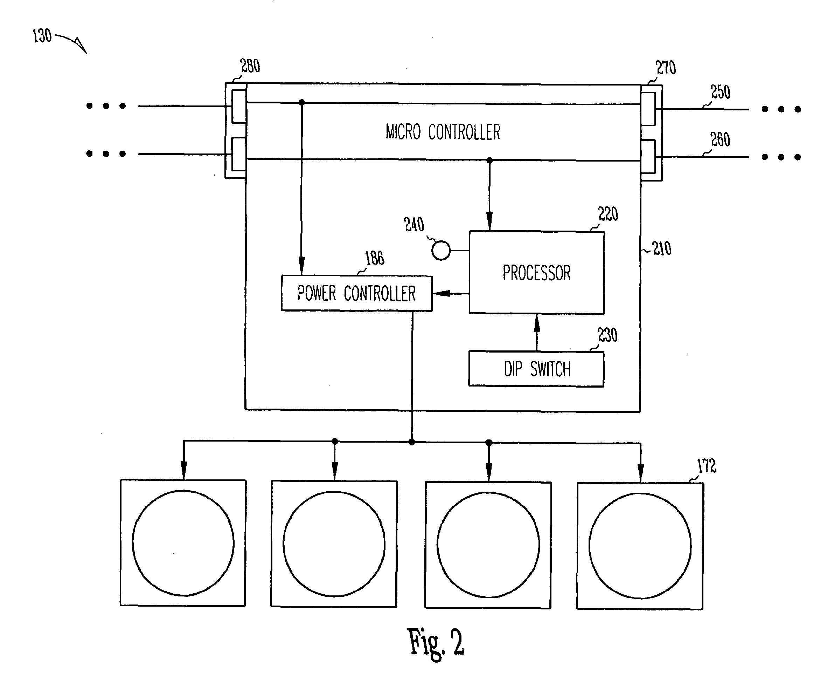

Referring now to FIG.2, there is illustrated an example embodiment of a fan assisted tile 130 shown in FIG.1. For example, as shown in FIG. 2, the fan assisted tile 130 includes a fan controller 210 coupled to one or more fans 172. The one or more fans 172 can be one or more axial and/or radial fans.

As shown in FIG.2, the fan controller 210 includes a processor 220, the power controller 186, DIP switch 230, sensor 240, and in and out interfaces 270 and 280 for daisy chaining with other fan assisted tiles 130. Further, as shown in FIG.1, the sensor 240 can be the temperature sensor 182, the airflow sensor 184 or any other sensor that is suitable for sensing environmental characteristics and can facilitate in adaptive airflow balancing and thermal management of the room 105. In some embodiments, sensor 240 can be a humidity sensor to sense humidity of air coming into and out of the room 105.

The DIP switch 230 facilitates in setting a Network address, such as an IP address that is unique to each of the fan assisted tiles 130. The DIP switch 230 can be an 8 bit or higher DIP switch. The DIP switch 230 can also be a programmable switch or the like that is suitable for setting a Network address or a unique identifier. As shown in FIG.2, the fan assisted tile 130 is coupled with other fan assisted tiles by daisy chaining the power and network connections using the interfaces 270 and 280. For example, in FIG. 2, power line 250 and network line 260 are shown isolated. The network line 260 can be an RS485 8bit addressable connection or a serial communication interface.

In operation, in one example embodiment, each of the temperature sensors 182 and the airflow sensors 184 sense the outgoing air temperature and the incoming airflow, respectively, and the processor 220 outputs a first control signal along with an associated Network address based on the sensed temperature and airflow. The first control signal can be temperature data, airflow data, and/or any other data that facilitates in adaptive airflow balancing or thermal management of the room 105.

In some embodiments, each of the temperature sensors 182 senses the outgoing temperature in the room 105 and the processor 220 outputs a first control signal, and each of the airflow sensors 184 senses the incoming airflow and outputs a second control signal. In these embodiments, the thermal server 190 outputs third and fourth control signals based on the outputted first and second control signals, respectively. Also in these embodiments, each of the fan controllers 210 varies the fan speed of one or more fans 172, in each of the associated fan assisted tiles 130 in the first and second arrays 110 and 120, based on the third and fourth control signals received from the thermal server 190 through the data network 180.

The thermal server 190 receives the outputted first control signal along with the associated Network address from each of the temperature and airflow sensors 182 and 184 through the data network 180, and outputs a second control signal along with the associated Network address based on the received first control signal and the associated Network address from each of the temperature and airflow sensors 182 and 184.

The thermal server 190 sends each of the outputted second control signals along with associated Network addresses through the data network 180 to an associated fan controller 210 of a fan assisted tile 130 based on the received Network address. The fan controller 210 of each fan assisted tile 130 controls the one or more fans 172 based on the received control signal from the thermal server 190 through the data network 180.

In some embodiments, the second control signal is revolutions-perminute (rpm) data or other such data that can aid in controlling the speed of one or more fans 172. In some embodiments, the microcontroller 210 controls the fan speed of the one or more fans 172 in each fan assisted tile 130 in the first array 110, based on the received associated first control signal, which can be based on the airflow data received from the associated airflow sensor 184. Also in these embodiments, the fan controller 210 controls the fan speed of the one or more fans 172 in each fan assisted tile 130 in the second array 120, based on the received associated second control signal, which can be the temperature data received from the associated temperature sensor 182, to provide adaptive airflow balancing and/or thermal management in the room 105.

Further, FIG. 1 shows an indicator 192 disposed in the room 105, in the ceiling 150 and/or the raised floor 140, to indicate a failed condition of each of the fan assisted tiles 130 should the fan assisted tiles fail during operation. The indicator 192 can be a light and/or an alarm. The light comes on and/or the alarm goes on when any of the associated fan assisted tiles 130 fails during operation. The indicator 192 can be coupled to the fan controller 210, which in turn can be coupled to the thermal server 190 through the data network 180. The fan controller 210 can also include a sensor (not shown) to monitor the status of each of the fan assisted tiles 130 disposed in the first and second arrays 110 and 120. In operation, the sensor can send a fifth control signal to the thermal server 190. The thermal server 190 can monitor the sent fifth control signal and output a sixth control signal to the fan controller 210. The fan controller 210 indicates the failed condition of a fan assisted tile 130 in the first and second arrays 110 and 120, respectively, based on the received sixth control signal.

It can be envisioned that the above-described techniques can also be used in a decentralized control environment, where the controller, such as the thermal server 190 leaves most of the operating decisions to the remote devices, such as the fan assisted tiles 130 and other devices coupled through the data network 130. In these embodiments, the thermal server 190 sends commands to each fan assisted tile 130 to operate at a level to achieve a given airflow or temperature. The decision regarding operating parameters, such as fan speed and other commands are made locally by each of the fan assisted tiles 130. In these embodiments, part of the control functions performed by the thermal server 190 is switched to each of the fan assisted tiles 130 to achieve an adaptive control in the room 105.

In addition, it can also be envisioned that the above-described techniques can be run in a distributed control environment, where each of the fan assisted tiles 130 or any other device can communicate with other fan assisted tiles 130 or devices coupled through the data network 180. Also in these embodiments, each of the fan assisted tiles 130 can compute their own operating parameters to control their fan speeds to achieve an adaptive control in the room 105. In these embodiments, the thermal server 190 would be basically used to monitor, the fan assisted tiles and other such devices connected through the network 180, for proper functioning and to report the status of each of these devices to a facilitator and/or an operator. The advantage of either of the above described architectures, i.e., the decentralized control system and the distributed control system, is that they can considerably reduce the communication traffic sent over the data network 180 to enhance system performance.

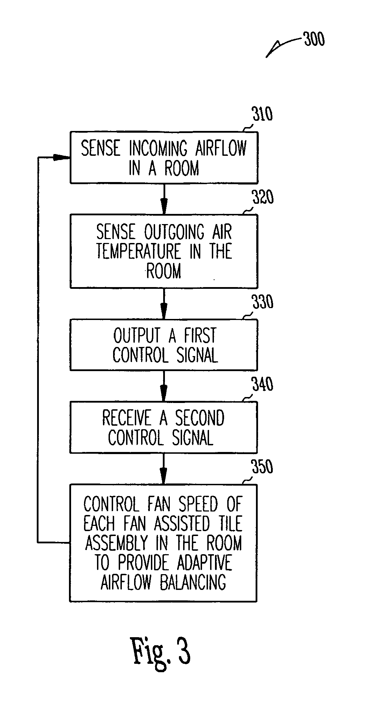

Referring now to FIG. 3, there is illustrated an embodiment of a method 300 according to the present invention. At 310, the method 300 in this example embodiment senses incoming airflow into a room. At 320, the method 300 further senses outgoing air temperature. In this embodiment, the incoming airflow from a first array of fan assisted tiles and the outgoing air temperature from a second array of fan assisted tiles is sensed.

At 330 a first control signal is outputted based on the sensed airflow and temperature. In some embodiments, at 330 a Network address associated with each fan assisted tile along with the first control signal is outputted at 330. At 340 a second control signal is outputted based on the first control signal. In some embodiments, at 340 the second control signal is outputted along with the Network address associated with the fan assisted tile to be controlled.

At 350 fan speed of the one or more fans 172 in each fan assisted tile in the first and second arrays is controlled based on the second control signal to provide adaptive airflow balancing in the room. In some embodiments, the method 300 can include sensing the condition of each fan assisted tile and indicating a failed condition based on sensing the condition of each fan assisted tile. In these embodiments, the failed condition of a fan assisted tile can be indicated by sending an alarm or by lighting an indicator associated with the failed fan assisted tile.

The above method, blocks 310-350, repeats itself to maintain adaptive airflow balancing and provide thermal management in the room by varying the speed of fans to accommodate changes in traffic patterns, component changes and additions, blocked filters, failed fans and so on in the room. The room can be a computer data center including heat generating components.

Although the method 300 includes blocks 310-350 that are arranged serially in the exemplary embodiments, other embodiments of the subject matter may execute two or more blocks in parallel, using multiple processors or a single processor organized two or more virtual machines or sub-processors. Moreover, still other embodiments may implement the blocks as two or more specific interconnected hardware modules with related control and data signals communicated between and through the modules, or as portions of an application-specific integrated circuit. Thus, the exemplary process flow diagrams are applicable to software, firmware, and/or hardware implementations.

The various embodiments of the fan assemblies, systems, and methods described herein are applicable generically to achieve adaptive airflow balancing and thermal management in a computer data center. In addition, the above-described technique provides uniform airflow in every location in a computer data center, thus helping to improve operating efficiency and cooling performance of the computer data center. Further, the above-described technique provides adaptive air flow balancing in a computer data center under varying thermal load distributions. Furthermore, the above-described technique, after achieving an operational thermal balance, continues to monitor the steady state situation and compensates for thermal variability due to time dependent variations in traffic patterns, blocked filters, failed fans, and other such variations to provide a well-balanced airflow.

## Claims

1. An environmental management system (100) for a room (105) having heat generating (195) or airflow sensitive components, the system comprising:
an array (110) of fan assisted tiles (130);
a fan controller (210) coupled to each fan assisted tile (130); and
a thermal server (190) coupled to each fan controller through a data network (180) to receive sensed data based on environmental characteristics in the room;
sensors (182, 184) associated with each fan assisted tile (130), wherein the sensors are coupled to the remote server (190), and sense environmental characteristics in the room (105) and output sensed data;
**characterized in that** the system (100) comprises a network of temperature sensors (199) separate from the fan assisted tiles and said thermal server is further coupled to the network of temperature sensors (199) in order to output a control signal to each fan controller (210) so that fans of each fan assisted tile (130) can be controlled to provide an adaptive airflow balancing in the room.

2. The environmental management system of claim 1, wherein the sensed data comprises data based on environmental characteristics selected from the group consisting of airflow, temperature, humidity, and particle density.

3. The environmental management system of claim 2, wherein the sensed data comprises environmental characteristics of air coming into and out of the room.

4. The environmental management system of claim 1 wherein the array of fan assisted tiles (130) comprises:
a first array (110) of fan assisted tiles having sensors to sense airflow, wherein the fan assisted tiles direct the airflow into the room (105);
a second array (120) of fan assisted tiles having sensors to sense temperature, wherein the fan assisted tiles direct the airflow out of the room; and
wherein the thermal server (190) is remote from the fan assisted tiles (130), receives sensed airflow data and temperature data from the sensors and from the array of temperature sensors via a wireless network and, outputs a control signal to vary fan speeds of each fan assisted tile in the first and second arrays and to control inlet and outlet vents (162) in the fan assisted tiles.

5. A method for providing adaptive thermal management of a room (105) having heat generating components, comprising:
providing an adaptive airflow balancing in the room by using an array of fan assisted tiles (130) that are controlled by a remote server (190) based on sensed environmental characteristics in the room, wherein sensors (182,184) associated with each fan assisted tile (130) are coupled to the remote server (190) sense environmental characteristics in the room and output sensed data and wherein temperature characteristics in the room are provided by a network of temperature sensors (199) independent from the fan assisted tiles (130).

6. The method of claim 5, wherein the environmental characteristics are sensed with respect to at least one of airflow, temperature, humidity, and particle density in air coming into or out of the room through each fan tile.

7. The method of claim 6 wherein each fan assisted tile (130) is controlled as a function of environmental characteristics using a remote computer through a network (180).

8. The method of claim 7, wherein controlling each fan assisted tile (130) as a function of the environmental characteristics further comprises:
outputting a first control signal and an associated Network address by each fan assisted tile assembly to the remote computer based on the sensed environmental characteristics;
receiving a second control signal and the associated Network address by each fan assisted tile assembly; and
controlling each fan assisted tile assembly based on the received second control signal and the associated Network address to provide adaptive airflow balancing in the room.

## Patentansprüche

1. Umweltmanagementsystem (100) für einen Raum (105) mit Wärme erzeugenden (195) oder für Luftströmungen empfindlichen Komponenten, wobei das System Folgendes umfasst:
eine Anordnung (110) von lüfterunterstützten Fliesen (130);
eine Lüftersteuerung (210), die mit jeder lüfterunterstützten Fliese (130) verbunden ist; und
einen Thermoserver (190), der über ein Datennetz (180) mit jeder Lüftersteuerung verbunden ist, um erfasste Daten zu empfangen, die auf Umweltkenndaten in dem Raum basieren;
Sensoren (182, 184), die mit jeder lüfterunterstützten Fliese (130) verknüpft sind, wobei die Sensoren mit dem Remote-Server (190) verbunden sind und Umweltkenndaten in dem Raum (105) erfassen und erfasste Daten ausgeben;
**dadurch gekenntzeichnet, dass** das System (100) ein Netz von Temperatursensoren (199) umfasst, die von den lüfterunterstützten Fliesen getrennt sind, und der Thermoserver weiterhin mit dem Netz von Temperatursensoren (199) verbunden ist, um ein Steuersignal an jede Lüftersteuerung (210) auszugeben, so dass Lüfter jeder lüfterunterstützten Fliese (130) dahingehend gesteuert werden können, einen adaptiven Luftströmungsausgleich in dem Raum bereitzustellen.

2. Umweltmanagementsystem nach Anspruch 1, wobei die erfassten Daten Daten umfassen, die auf Umweltkenndaten basieren, die aus der Gruppe bestehend aus Luftströmung, Temperatur, Luftfeuchtigkeit und Teilchendichte ausgewählt sind.

3. Umweltmanagementsystem nach Anspruch 2, wobei die erfassten Daten Umweltkenndaten von Luft umfassen, die in den Raum hinein und aus dem Raum hinaus strömt.

4. Umweltmanagementsystem nach Anspruch 1, wobei die Anordnung von lüfterunterstützten Fliesen (130) Folgendes umfasst:
eine erste Anordnung (110) von lüfterunterstützten Fliesen mit Sensoren zum Erfassen der Luftströmung, wobei die lüfterunterstützten Fliesen die Luftströmung in den Raum (105) hinein leiten;
eine zweite Anordnung (120) von lüfterunterstützten Fliesen mit Sensoren zum Erfassen der Temperatur, wobei die lüfterunterstützten Fliesen die Luftströmung aus dem Raum hinaus leiten; und
wobei der Thermoserver (190) von den lüfterunterstützten Fliesen (130) entfernt ist, über ein drahtloses Netz erfasste Luftströmungsdaten und Temperaturdaten von den Sensoren und von der Anordnung von Temperatursensoren empfängt und ein Steuersignal zum Ändern der Lüftergeschwindigkeiten jeder lüfterunterstützten Fliese in der ersten und der zweiten Anordnung und zum Steuern der Lufteinlässe und -auslässe (162) in den lüfterunterstützten Fliesen ausgibt.

5. Verfahren zum Bereitstellen von adaptivem Thermomanagement eines Raums (105) mit Wärme erzeugenden Komponenten, wobei das Verfahren Folgendes umfasst:
Bereitstellen eines adaptiven Luftströmungsausgleichs in dem Raum durch Verwendung einer Anordnung von lüfterunterstützten Fliesen (130), die von einem Remote-Server (190) auf Basis von erfassten Umweltkenndaten in dem Raum gesteuert werden, wobei Sensoren (182, 184), die mit jeder lüfterunterstützten Fliese (130) verknüpft sind, mit dem Remote-Server (190) verbunden sind, Umweltkenndaten in dem Raum erfassen und erfasste Daten ausgeben und
wobei Temperaturkenndaten in dem Raum von einem Netz von Temperatursensoren (199) bereitgestellt werden, die von den lüfterunterstützten Fliesen (130) unabhängig sind.

6. Verfahren nach Anspruch 5, wobei die Umweltkenndaten im Hinblick auf die Luftströmung, die Temperatur, die Luftfeuchtigkeit und/oder die Teilchendichte in Luft erfasst werden, die durch jede Lüfterfliese in den Raum hinein oder aus dem Raum hinaus strömt.

7. Verfahren nach Anspruch 6, wobei jede lüfterunterstützte Fliese (130) in Abhängigkeit von Umweltkenndaten unter Verwendung eines Remote-Computers über ein Netz (180) gesteuert wird.

8. Verfahren nach Anspruch 7, wobei das Steuern jeder lüfterunterstützten Fliese (130) in Abhängigkeit der Umweltkenndaten weiterhin Folgendes umfasst:
Ausgeben eines ersten Steuersignals und einer zugehörigen Netzadresse von jeder Gruppe von lüfterunterstützten Fliesen an den Remote-Computer auf Basis der erfassten Umweltkenndaten;
Empfangen eines zweiten Steuersignals und der zugehörigen Netzadresse von jeder Gruppe von lüfterunterstützten Fliesen und
Steuern jeder Gruppe von lüfterunterstützten Fliesen auf Basis des empfangenen zweiten Steuersignals und der zugehörigen Netzadresse, um adaptiven Luftströmungsausgleich in dem Raum bereitzustellen.

## Revendications

1. Système de gestion d'environnement (100) pour un local (105) équipé de composants produisant de la chaleur (195) ou sensibles à un flux d'air, le système comprenant :
un ensemble (110) de dalles ventilées (130) ;
un contrôleur de ventilateur (210) couplé à chaque dalle ventilée (130) ; et
un serveur thermique (190) couplé à chaque contrôleur de ventilateur par l'intermédiaire d'un réseau de données (180) afin de recevoir des données ayant été détectées sur la base des caractéristiques environnementales régnant dans le local ;
des capteurs (182, 184) associés à chaque dalle ventilée (130), cas dans lequel les capteurs sont couplés au serveur distant (190), et détectent les caractéristiques environnementales régnant dans le local (105) et génèrent les données détectées ;
**caractérisé en ce que** le système (100) comprend un réseau de capteurs de température (199) qui sont séparés des dalles ventilées et ledit serveur thermique est couplé en outre au réseau de capteurs de température (199) afin d'acheminer un signal de commande vers chaque contrôleur de ventilateur (210) pour qu'il soit possible de piloter les ventilateurs de chaque dalle ventilée (130) afin de procurer un équilibrage adaptatif du flux d'air dans le local.

2. Système de gestion d'environnement selon la revendication 1, les données détectées englobant des données sur la base de caractéristiques environnementales sélectionnées parmi le groupe constitué des éléments suivants, à savoir flux d'air, température, humidité et densité des particules.

3. Système de gestion d'environnement selon la revendication 2, les données détectées englobant des caractéristiques environnementales de l'air arrivant dans le local et en sortant.

4. Système de gestion d'environnement selon la revendication 1, l'ensemble de dalles ventilées (130) comprenant :
un premier ensemble (110) de dalles ventilées qui comportent des capteurs destinés à détecter le flux d'air, cas dans lequel les dalles ventilées dirigent le flux d'air dans le local (105) ;
un deuxième ensemble (120) de dalles ventilées qui comportent des capteurs destinés à détecter la température, cas dans lequel les dalles ventilées dirigent le flux d'air hors du local ; et
cas dans lequel le serveur thermique (190) est situé à distance des dalles ventilées (130), reçoit les données de flux d'air et les données de température ayant été détectées à partir des capteurs et à partir de l'ensemble des capteurs de température par l'intermédiaire d'un réseau sans fil et génère un signal de commande pour faire varier les régimes de ventilation de chaque dalle ventilée dans le premier ensemble et dans le deuxième ensemble et pour piloter les évents d'admission et de sortie (162) prévus sur les dalles ventilées.

5. Procédé pour procurer une gestion thermique adaptative d'un local (105) équipé de composants produisant de la chaleur, comprenant :
l'opération consistant à procurer un équilibrage adaptatif du flux d'air dans le local grâce à l'utilisation d'un ensemble de dalles ventilées (130) qui sont pilotées par un serveur distant (190) sur la base des caractéristiques environnementales ayant été détectées dans le local, cas dans lequel les capteurs (182, 184) associés à chaque dalle ventilée (130) sont couplés au serveur distant (190), détectent les caractéristiques environnementales régnant dans le local et génèrent des données ayant été détectées et cas dans lequel les caractéristiques de température régnant dans le local sont fournies par un réseau de capteurs de température (199) qui sont indépendants des dalles ventilées (130).

6. Procédé selon la revendication 5, les caractéristiques environnementales étant détectées par rapport à l'un au moins des éléments suivants, à savoir flux d'air, température, humidité et densité des particules dans l'air arrivant dans le local, et en sortant, par l'intermédiaire de chaque dalle ventilée.

7. Procédé selon la revendication 6, chaque dalle ventilée (130) étant pilotée en fonction des caractéristiques environnementales grâce à l'utilisation d'un ordinateur distant, par l'intermédiaire d'un réseau (180).

8. Procédé selon la revendication 7, le pilotage de chaque dalle ventilée (130) en fonction des caractéristiques environnementales comprenant en outre :
l'opération consistant à acheminer, pour chaque module de dalle ventilée, un premier signal de commande et une adresse Réseau associée vers l'ordinateur distant sur la base des caractéristiques environnementales ayant été détectées ;
l'opération consistant à recevoir un deuxième signal de commande et l'adresse Réseau associée au niveau de chaque module de dalle ventilée ; et
l'opération consistant à piloter chaque module de dalle ventilée sur la base du deuxième signal de commande et de l'adresse Réseau associée ayant été reçus, afin de procurer un équilibrage adaptatif du flux d'air dans le local.
